# EUROPEAN PATENT SPECIFICATION

(11) **EP 4 243 241 B1**
(45) Date of publication and mention of the grant of the patent: **06.08.2025**
(21) Application number: 22887623.1
(22) Date of filing: 26.10.2022
(51) Int. Cl.: H02J 7/34, H02J 7/00, G01R 31/371

(54) **POWER BANK HAVING FUNCTION FOR PROVIDING RECHARGEABLE RANGE OF BATTERY PACK, BATTERY PACK CHARGING SYSTEM COMPRISING SAME, AND METHOD THEREFOR**
POWERBANK MIT FUNKTION ZUR BEREITSTELLUNG EINES WIEDERAUFLADBAREN BEREICHS EINES BATTERIEPACKS, BATTERIEPACKLADESYSTEM DAMIT UND VERFAHREN DAFÜR
BATTERIE EXTERNE AYANT UNE FONCTION POUR FOURNIR UNE PLAGE RECHARGEABLE DE BLOC-BATTERIE, SYSTÈME DE CHARGE DE BLOC-BATTERIE LA COMPRENANT, ET PROCÉDÉ ASSOCIÉ

(30) Priority: 28.10.2021 KR 20210145885
(43) Date of publication of application: 13.09.2023
(73) Proprietor: LG Energy Solution, Ltd., Seoul 07335 (KR)
(72) Inventor: SONG, Kee Hoon, Daejeon 34122 (KR); KIM, Jun Suk, Daejeon 34122 (KR); AN, Hyo Seong, Daejeon 34122 (KR)
(74) Representative: Plasseraud IP
(86) International application number: PCT/KR2022/016501
(87) International publication number: WO 2023/075427

(56) References cited:
- WO-A1-2018/129972
- JP-A- 2018 170 815
- KR-A- 20070 117 260
- KR-A- 20150 142 216
- KR-A- 20160 022 179
- KR-B1- 101 501 031
- US-A1- 2020 136 422
- US-A1- 2021 296 917
- US-B2- 10 298 039

## Description

### TECHNICAL FIELD

The present invention relates to a power bank having a function of providing a chargeable range of a battery pack, and the battery pack charging system including the same, and the method thereof.

### BACKGROUND ART

Recently, as the number of people who enjoy camping increases, the demand for a power bank is increasing to use an electronic device in outdoor environments where an electric outlet is not available. In addition, an auxiliary battery is widely used to charge and use various electronic devices including a mobile phone and a notebook computer.

In order to prevent a sudden unusable situation from occurring due to battery exhaustion of the electronic device in outdoor environments, it is important to predict and use how much the power bank or auxiliary battery can charge the electronic device that a charging counterpart.

However, in the case of most current power banks and auxiliary batteries, only the remaining capacity information of the power bank or auxiliary battery is provided through an external LED, and information on how far the charging target (electronic device) can be charged with the current power of the power bank or auxiliary battery is not provided. Accordingly, the user is using the power bank and the auxiliary battery depending on empirical rough information (LED) without knowing exact information about chargeable capacity of the charging counterpart and accordingly, a problem accompanied by inconvenience and anxiety occurs in the process of using it.

As such prior art, there is a following patent document.

Patent literature 1: KR 1561069 B1. US2020/136422 A1, US2021/296917 A1, KR 20070117260 A, WO2018/129972 A1, KR2016 0022179 A, KR101501031 B1, JP2018 170815 A, KR2015 0142216 A and US10298039 B2 each relate to the charging of a device using an external battery pack.

### DISCLOSURE OF THE INVENTION

### TECHNICAL PROBLEM

The present invention is intended to solve the problems described above, and is to provide information on how far the charging counterpart can be charged through an external display of the power bank (auxiliary battery) based on the remaining capacity of the power bank (auxiliary battery) and the current capacity of the charging counterpart after checking the capacity information through communication between the power bank (auxiliary battery) and the charging counterpart.

### TECHNICAL SOLUTION

The present invention provides a power bank according to claim 1.

In addition, the present invention provides a method according to claim 7.

In this case, the chargeable range determination step may be configured to include a capacity comparison step of comparing the sum capacity of the remaining capacity of the power bank calculated in the remaining capacity information calculation step and the measured capacity of the battery pack received in the measured capacity information receiving step with the buffer capacity of the battery pack, and a chargeable capacity derivation step of deriving the chargeable capacity of the battery pack according to the comparison result in the capacity comparison step.

In this case, in the chargeable capacity derivation step, when the sum capacity of the remaining capacity of the power bank and the measured capacity of the battery pack is equal to or greater than the buffer capacity of the battery pack as the result of the comparison in the capacity comparison step, the chargeable capacity of the battery pack is derived as 100%, and when the sum capacity of the remaining capacity of the power bank and the measured capacity of the battery pack is less than the buffer capacity of the battery pack as the result of the comparison of the capacity comparison step, an SOC value corresponding to the sum capacity is extracted from the capacity and SOC table, in which a capacity for each OCV and an SOC (%) are recorded, obtained from the battery pack and the extracted SOC value (%) is derived as the chargeable capacity of the battery pack.

### ADVANTAGEOUS EFFECTS

The present invention can improve user convenience by providing information on the chargeable capacity of the charging target (battery pack) to the external display of the power bank (auxiliary battery) based on the remaining capacity of the power bank after checking the capacity information through communication between the power bank and the charging target.

### BRIEF DESCRIPTION OF THE DRAWINGS

FIG. 1 is a diagram illustrating a battery pack charging system including a power bank according to the present invention.
FIG. 2 is a diagram illustrating an example of a capacity and SOC table according to the present invention.
FIG. 3 is a diagram illustrating a method for charging a battery pack with the power bank according to the present invention.

### MODE FOR CARRYING OUT THE INVENTION

Hereinafter, embodiments of the present invention will be described in detail with reference to the accompanying drawings so that those of ordinary skill in the art can easily carry out the present invention. In order to clearly explain the present invention in the drawings, parts irrelevant to the description are omitted, and similar reference numerals are assigned to similar parts throughout the specification.

Hereinafter, the present invention will be described in detail with reference to the drawings.

### 1. Battery pack charging system according to the present invention

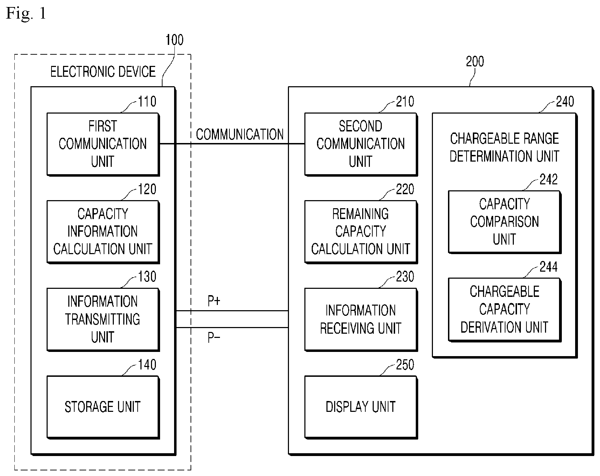

FIG. 1 is a diagram schematically illustrating a power bank having a chargeable capacity providing function according to the present invention and a battery pack charging system including the same.

Referring to FIG. 1, the battery pack charging system of the present invention is configured to include a power bank 200 and a battery pack 100 charged by receiving charging power from the power bank 200.

### 1.1. Battery pack 100

The battery pack 100 is a configuration that is charged by receiving charging power from the power bank 200 through a charging terminal (not illustrated and functions as a power driving source for an electronic device (e.g., a mobile phone, a laptop, etc.) in which the battery pack 100 is mounted.

The battery pack 100 of the present invention may be configured to include the following detailed configurations.

### 1.1.1. First communication unit 110

The first communication unit 110 is a configuration for mutual data communication with the power bank (200). More specifically, it is communicatively connected to a second communication unit 210 of the power bank 200 to be described later. The data communication connection may be made in a wired or wireless connection method.

### 1.1.2. Capacity information calculation unit 120

The capacity information calculation unit 120 measures an open circuit voltage (OCV, open circuit voltage) value of the battery pack 100, and calculates a measured capacity by using the measured OCV value.

A known technique is used in calculating the measured capacity according to the OCV measured value.

### 1.1.3. Information transmitting unit 130

The information transmitting unit 130 is a configuration that transmits the measured capacity of the battery pack 100 calculated by the capacity information calculating unit 120, a capacity, and an SOC table stored in a storage unit 140 to be described later to the power bank 200 through the first communication unit 110.

### 1.1.4. Storage unit 140

The storage unit 140 is a configuration that stores a capacity and SOC table in which a capacity for each open circuit voltage (OCV) and a state of charge (SOC, %) corresponding thereto is recorded, prepared in advance through an experiment.

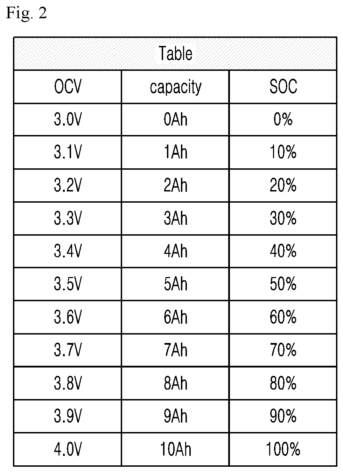

The capacity and SOC table may be, for example, in the form of the table shown in FIG. 2.

### 1.2. Power bank or Auxiliary battery 200

The power bank or auxiliary battery 200 is a device for charging a connected electronic device (e.g., the mobile phone, laptop, etc.) (not illustrated) by applying power stored in a battery provided therein to the battery pack 100 built in the connected electronic device.

The power bank 200 of the present invention is configured to receive capacity information of the battery pack 100 through a communication connection with the battery pack 100, and provide information on a chargeable capacity of the battery pack 100 based on the received capacity information of the battery pack 100 and a remaining capacity of the power bank 200.

Such a power bank 200 includes a power bank battery, and may be configured to further include the following detailed configuration.

### 1.2.1. Second communication unit 210

The second communication unit 210 is a configuration for mutual data communication with the charging target battery pack 100 to be charged. More specifically, it is communicatively connected to the first communication unit 110 of the battery pack 100 described above. The data communication connection may be made in a wired or wireless connection method.

### 1.2.2. Remaining capacity calculation unit 220

The remaining capacity calculation unit 220 is a configuration that calculates a remaining capacity of the power bank 200, specifically, the remaining capacity of a power bank battery (not illustrated) built in the power bank 200.

A known technique is used in calculating the remaining capacity.

### 1.2.3. Information receiving unit 230

The information receiving unit 230 is a configuration that receives the measured capacity information of the battery pack 100 and the capacity SOC table from the battery pack 100 through the second communication unit 210.

### 1.2.4. Chargeable range determination unit 240

The chargeable range determination unit is a configuration that compares a sum capacity of the measured capacity of the battery pack 100 received by the information receiving unit 230 and the remaining capacity of the power bank 200 calculated by the remaining capacity calculation unit 220 with a buffer capacity of the battery pack 100 to determine a chargeable range of the battery pack 100 with the power of the power bank 200 according to the comparison result.

The chargeable range determination unit 240 may be configured to include the following detailed configuration.

### a. Capacity comparison unit 242

The capacity comparison unit 242 is a configuration that compares the sum capacity of the measured capacity of the battery pack 100 received by the information receiving unit 230 and the remaining capacity of the power bank 200 calculated by the remaining capacity calculation unit 220 with the buffer capacity of the battery pack 100.

### b. Chargeable capacity derivation unit 244

The chargeable capacity derivation unit 244 is a configuration that derives the chargeable capacity of the battery pack 100 with the power of the power bank 200 according to the comparison result of the capacity comparison unit 242.

Specifically, as a result of the comparison, when the sum capacity is equal to or greater than the buffer capacity of the battery pack 100, the chargeable capacity of the battery pack 100 may be derived as 100%.

On the other hand, as a result of the comparison, when the sum capacity is less than the buffer capacity of the battery pack 100, an SOC value corresponding to the sum capacity may be extracted from the capacity and SOC table in which the capacity for each OCV from the battery pack 100 and the SOC (%) is recorded from the battery pack 100, and the extracted SOC value (%) may be derived as the chargeable capacity of the battery pack.

For example, when described with reference to the table of FIG. 2, if the measured capacity of the battery pack 100 is 6 Ah and that of the power bank 200 is 3 Ah, the sum capacity of the capacity of the battery pack and the capacity of the power bank is 9 Ah. In this case, since the sum capacity is less than the buffer capacity 10 Ah of the battery pack, 90%, which is an SOC value corresponding to 9 Ah, is derived from the capacity and SOC table as shown in the table of FIG. 2, and this is derived as the chargeable capacity of the battery pack 100.

### 1.2.5. Display unit 250

The display unit 250 is a configuration that displays the chargeable range of the battery pack 100 determined by the chargeable range determination unit 240 so that the user can check the chargeable range.

More specifically, when the chargeable capacity derived from the chargeable capacity derivation unit 244 of the chargeable range determination unit 240 is 90%, the display unit displays it externally. The display unit of the present invention may include a first display unit displaying the remaining capacity of the power bank and a second display unit that numerically displays how much the battery pack 100, that is, a counterpart to be charged, can be charged.

Such configurations of the power bank 200 may be implemented in a battery management system (BMS) of the power bank 200.

### 2. Battery pack charging method according to the present invention

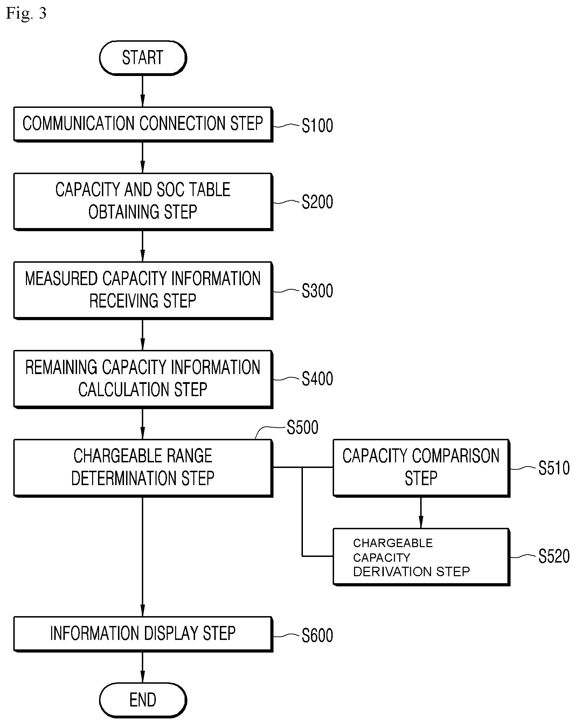

FIG. 3 is a diagram illustrating a method of charging the battery pack with the power bank having the function of providing a chargeable range of the battery pack according to the present invention.

Referring to FIG. 3, the method of the present invention may be configured to include the following steps.

### 2.1. Communication connection step S100

The communication connection step S100 is a step of connecting data communication between the power bank or the auxiliary battery 200 and the battery pack 100 charged by receiving charging power from the power bank 200.

The data communication connection may be made in a wired or wireless connection method.

### 2.2. Capacity and SOC table obtaining step S200

The capacity and SOC table obtaining step S200 is a step of obtaining, by the power bank 200, a capacity and SOC table in which a capacity for each open circuit voltage (OCV) and SOC (%) are recorded from the battery pack 100 which is communicatively connected in the communication connection step S100.

Here, the capacity and SOC table may be, for example, in the form of a table as shown in FIG. 2.

### 2.3. Measured capacity information receiving step S300

The measured capacity information receiving step S300 is a step of receiving, by the power bank 200, a measured capacity according to an OCV measurement value of the battery pack 100 from the battery pack which is communicatively connected.

Here, in calculating the measured capacity by the battery pack 100, the open circuit voltage (OCV) value of the battery pack 100 is measured and the measured capacity is calculated using the measured OCV value.

A known technique is used in calculating the measured capacity according to the OCV measured value.

### 2.4. Remaining capacity information calculation step S400

The remaining capacity information calculation step S400 is a step of measuring/calculating the remaining capacity of the power bank 200. More specifically, the remaining capacity of the battery (not illustrated) built in the power bank 200 is calculated.

A known technique is used in calculating the remaining capacity.

### 2.5. Chargeable range determination step S500

The chargeable range determination step S500 is a step of comparing, by the power bank 200, a sum capacity of the calculated remaining capacity of the power bank 200 and the measured capacity received from the battery pack 100 with a buffer capacity of the battery pack 100 to determine a chargeable range of the battery pack with the power of the power bank 200 according to the comparison result.

This chargeable range determination step (S500) may be configured to include the following detailed steps.

### 2.5.1. Capacity comparison step S510

The capacity comparison step S510 is a step of comparing the sum of the remaining capacity of the power bank 200 calculated in the remaining capacity information calculation step S400 and the measured capacity of the battery pack 100 received in the measured capacity information receiving step S300 with the buffer capacity of the battery pack 100.

### 2.5.2. Chargeable capacity derivation step S520

In the chargeable capacity derivation step S520, the chargeable capacity of the battery pack 100 is derived with the power of the power bank 200 according to the comparison result of the capacity comparison step S510.

Specifically, when the sum of the remaining capacity of the power bank 200 and the measured capacity of the battery pack 100 is equal to or greater than the buffer capacity of the battery pack as the result of the comparison in the capacity comparison step S510, the chargeable capacity of the battery pack 100 may be derived as 100%.

On the other hand, when the sum capacity of the remaining capacity of the power bank 200 and the measured capacity of the battery pack 100 is less than the buffer capacity of the battery pack as the result of the comparison of the capacity comparison step S510, an SOC value corresponding to the sum capacity may be extracted from the capacity and SOC table, in which the capacity for each OCV and the SOC (%) are recorded, obtained from the battery pack 100, and the extracted SOC value (%) may be derived as the chargeable capacity of the battery pack 100.

For example, when described with reference to the table of FIG. 2, if the measured capacity of the battery pack 100 is 6 Ah and that of the power bank 200 is 3 Ah, the sum capacity of the capacity of the battery pack and the capacity of the power bank is 9 Ah. In this case, since the sum capacity is less than the buffer capacity 10 Ah of the battery pack, 90%, which is an SOC value corresponding to 9 Ah, is derived from the capacity and SOC table as shown in the table of FIG. 2, and this is derived as the chargeable capacity of the battery pack 100.

### 2.6. Information display step S600

The information display step S600 is a step of displaying the chargeable capacity value (%) derived in the chargeable capacity derivation step S520 of the chargeable range determination step S500 on an external display 250 provided in the power bank 200.

In this way, information on how far the battery pack can be charged based the remaining capacity of the power bank and the measured capacity of the battery pack through communication between the power bank (auxiliary battery) and the battery pack built into the charging counterpart (electronic device) is displayed and provided to the user, thereby capable of increasing convenience and satisfaction with use of the user.

Meanwhile, although the technical idea of the present invention has been described in detail according to the above embodiments, it should be noted that the above embodiments are for description and not for limitation. In addition, those skilled in the art will understand that various embodiments are possible within the scope of the present invention.

Although the power bank having a function of providing a chargeable range of a battery pack, the battery pack charging system including the same, and the method therefor have been described with reference to the specific embodiments, they are not limited thereto. Therefore, it will be readily understood by those skilled in the art that various modifications and changes can be made thereto without departing from the scope of the present invention defined by the appended claims.

## Claims

1. A power bank (200) comprising:
a power bank battery;
a communication unit (210) connectable to a charging target battery pack to be charged through wired/wireless communication;
a remaining capacity calculation unit (220) that is configured to calculate a remaining capacity of the power bank battery;
an information receiving unit (230) that is configured to receive measured capacity information of the charging target battery pack and a capacity and state of charge, SOC, table from the charging target battery pack through the communication unit (210);
a chargeable range determination unit (240) that is configured to compare a sum capacity of the measured capacity of the charging target battery pack received by the information receiving unit (230) and the remaining capacity of the power bank calculated by the remaining capacity calculation unit (220) with a buffer capacity of the charging target battery pack to determine a chargeable range of the charging target battery pack according to the comparison result; the buffer capacity of the charging target battery pack being the capacity corresponding to 100% SOC in the capacity and state of charge, SOC, table; and
a display unit (250) that is configured to externally display the chargeable range of the charging target battery pack determined by the chargeable range determination unit.

2. The power bank (200) of claim 1, wherein
the chargeable range determination unit (240) comprises:
a capacity comparison unit (242) that is configured to compare the sum capacity of the measured capacity of the charging target battery pack received by the information receiving unit (230) and the remaining capacity of the power bank calculated by the remaining capacity calculation unit (220) with the buffer capacity of the charging target battery pack, and
a chargeable capacity derivation unit (244) that is configured to derive a chargeable capacity percentage of the charging target battery pack with power of the power bank according to the comparison result of the capacity comparison unit (242).

3. The power bank (200) of claim 2, wherein
the chargeable capacity derivation unit (244):
is configured to derive the chargeable capacity of the charging target battery pack as 100% when the sum capacity is equal to or greater than the buffer capacity of the charging target battery pack as a result of the comparison of the capacity comparison unit, (242) and
extract an SOC value corresponding to the sum capacity from the capacity and SOC table obtained from the charging target battery pack to derive the extracted SOC value percentage as the chargeable capacity of the charging target battery pack, when the sum capacity is less than the buffer capacity of the charging target battery pack as a result of the comparison of the capacity comparison unit (242).

4. The power bank of claim 3, wherein
the display unit (250) is configured to display a number of the extracted SOC value percentage.

5. A battery pack charging system configured to comprise the power bank (200) according to claim 1 and a battery pack (100) for charging by receiving charging power from the power bank (200), wherein
the battery pack (100) comprises a first communication unit (110) for data communication.

6. The battery pack charging system of claim 5, wherein
the battery pack (100) further comprises:
a capacity information calculation unit (120) that is configured to measure a value of open circuit voltage, OCV, of the battery pack (100) and calculate the measured capacity using the measured value of OCV,
an information transmitting unit (130) that is configured to transmit the measured capacity of the battery pack (100) calculated by the capacity information calculation unit (120) and the capacity and SOC table of a storage unit (140) to the power bank through the first communication unit (110), and
the storage unit (140) is configured to store the capacity and SOC table in which a capacity for each OCV and a state of charge percentage, SOC, are recorded.

7. A method for charging a battery pack (100) comprising:
a communication connection step (S100) of connecting mutual data communication between a power bank (200) and a battery pack (100) charged by receiving charging power from the power bank (200);
a capacity and state of charge, SOC, table obtaining step (S200) of obtaining, by the power bank (200), a capacity and SOC table, in which a capacity for each open circuit voltage, OCV, and a SOC percentage are recorded, from the battery pack (100) which is communicatively connected in the communication connection step;
a measured capacity information receiving step (S300) of receiving, by the power bank (200), a measured capacity according to an OCV measured value of the battery pack (100) from the battery pack (100) which is communicatively connected in the communication connection step;
a remaining capacity information calculation step (S400) of calculating, by the power bank (200), a remaining capacity of the power bank (200);
a chargeable range determination step (S500) of comparing, by the power bank (200), a sum capacity of the calculated remaining capacity of the power bank (200) and the measured capacity of the battery pack (100) received from the battery pack (100) with a buffer capacity of the battery pack (100) to determine a chargeable range of the battery pack (100) according to the comparison result; the buffer capacity of the charging target battery pack being the capacity corresponding to 100% SOC in the capacity and state of charge, SOC, table; and
an information display step (S600) of displaying, by the power bank (200), the determined chargeable range percentage of the battery pack (100) on an external display.

8. The method of claim 7, wherein the chargeable range determination step (S500) comprises:
a capacity comparison step (S510) of comparing the sum capacity of the remaining capacity of the power bank calculated in the remaining capacity information calculation step and the measured capacity of the battery pack (100) received in the measured capacity information receiving step with the buffer capacity of the battery pack (100), and
a chargeable capacity derivation step (S520) of deriving the chargeable capacity of the battery pack (100) according to the comparison result in the capacity comparison step.

9. The method of claim 8, wherein
in the chargeable capacity derivation step (S520),
when the sum capacity of the remaining capacity of the power bank (200) and the measured capacity of the battery pack (100) is equal to or greater than the buffer capacity of the battery pack (100) as the result of the comparison in the capacity comparison step, the chargeable capacity of the battery pack is derived as 100%.

10. The method of claim 8, wherein
in the chargeable capacity derivation step (520),
when the sum capacity of the remaining capacity of the power bank (200) and the measured capacity of the battery pack (100) is less than the buffer capacity of the battery pack (100) as the result of the comparison of the capacity comparison step, an SOC value corresponding to the sum capacity is extracted from the capacity and SOC table, in which the capacity for each OCV and the SOC percentage are recorded, obtained from the battery pack (100) and the extracted SOC value percentage is derived as the chargeable capacity of the battery pack (100).

## Patentansprüche

1. Powerbank (200), umfassend:
eine Powerbankbatterie;
eine Kommunikationseinheit (210), welche mit einem Ladungs-Zielbatteriepack, welches zu laden ist, durch drahtgebundene/drahtlose Kommunikation verbindbar ist;
eine Berechnungseinheit (220) einer verbleibenden Kapazität, welche dazu eingerichtet ist, eine verbleibende Kapazität der Powerbankbatterie zu berechnen;
eine Informationen erhaltende Einheit (230), welche dazu eingerichtet ist, durch die Kommunikationseinheit (210), gemessene Kapazitätsinformationen des Ladungs-Zielbatteriepacks und eine Kapazitäts- und Ladezustands-SOC-Tabelle von dem Ladungs-Zielbatteriepack zu erhalten;
eine Bestimmungseinheit (240) eines ladbaren Bereichs, welche dazu eingerichtet ist, eine Summenkapazität der gemessenen Kapazität des Ladungs-Zielbatteriepacks, welche durch die Informationen erhaltende Einheit (230) erhalten worden ist, und die verbleibende Kapazität der Powerbank, welche durch die Berechnungseinheit (220) einer verbleibenden Kapazität berechnet worden ist, mit einer Pufferkapazität des Ladungs-Zielbatteriepacks zu vergleichen, um einen ladbaren Bereich des Ladungs-Zielbatteriepacks gemäß dem Vergleichsergebnis zu bestimmen;
wobei die Pufferkapazität des Ladungs-Zielbatteriepacks die Kapazität ist, welche 100% SOC in der Kapazitäts- und Ladezustands-SOC-Tabelle entspricht; und
eine Anzeigeeinheit (250), welche dazu eingerichtet ist, extern den ladbaren Bereich des Ladungs-Zielbatteriepacks anzuzeigen, welcher durch die Bestimmungseinheit eines ladbaren Bereichs bestimmt worden ist.

2. Powerbank (200) nach Anspruch 1, wobei
die Bestimmungseinheit (240) eines ladbaren Bereichs umfasst:
eine Kapazitäts-Vergleichseinheit (242), welche dazu eingerichtet ist, die Summenkapazität der gemessenen Kapazität des Ladungs-Zielbatteriepacks, welche durch die Informationen erhaltende Einheit (230) erhalten worden ist, und die verbleibende Kapazität der Powerbank, welche durch die Berechnungseinheit (220) einer verbleibenden Kapazität berechnet worden ist, mit der Pufferkapazität des Ladungs-Zielbatteriepacks zu vergleichen; und
eine Ableitungseinheit (244) einer ladbaren Kapazität, welche dazu eingerichtet ist, einen ladbaren Kapazitätsprozentsatz des Ladungs-Zielbatteriepacks mit einer Leistung der Powerbank gemäß dem Vergleichsergebnis der Kapazitäts-Vergleichseinheit (242) abzuleiten.

3. Powerbank (200) nach Anspruch 2, wobei
die Ableitungseinheit (244) einer ladbaren Kapazität:
dazu eingerichtet ist, die ladbare Kapazität des Ladungs-Zielbatteriepacks, als ein Ergebnis des Vergleichs der Kapazitäts-Vergleichseinheit (242), als 100% abzuleiten, wenn die Summenkapazität gleich wie oder größer als die Pufferkapazität des Ladungs-Zielbatteriepacks ist, und
einen SOC-Wert zu extrahieren, welcher der Summenkapazität von der Kapazitäts- und SOC-Tabelle entspricht, welche von dem Ladungs-Zielbatteriepack erlangt worden ist, um den extrahierten SOC-Wert-Prozentsatz, als ein Ergebnis des Vergleichs der Kapazitäts-Vergleichseinheit (242), als die ladbare Kapazität des Ladungs-Zielbatteriepacks abzuleiten, wenn die Summenkapazität kleiner als die Pufferkapazität des Ladungs-Zielbatteriepacks ist.

4. Powerbank nach Anspruch 3, wobei
die Anzeigeeinheit (250) dazu eingerichtet ist, eine Zahl des extrahierten SOC-Wertprozentsatzes anzuzeigen.

5. Batteriepackladesystem, welches dazu eingerichtet ist, die Powerbank (200) nach Anspruch 1 und einen Batteriepack (100) zum Laden durch Erhalten von Ladeleistung von der Powerbank (200) zu umfassen, wobei
der Batteriepack (100) eine erste Kommunikationseinheit (110) zur Datenkommunikation umfasst.

6. Batteriepackladesystem nach Anspruch 5, wobei
der Batteriepack (100) ferner umfasst:
eine Berechnungseinheit (120) einer Kapazitätsinformation, welche dazu eingerichtet ist, einen Wert einer Leerlaufspannung, OCV, des Batteriepacks (100) zu messen und die gemessene Kapazität unter Verwendung des gemessenen OCV-Wertes zu berechnen,
eine Informationsübermittlungseinheit (130), welche dazu eingerichtet ist, die gemessene Kapazität des Batteriepacks (100), welche durch die Berechnungseinheit (120) einer Kapazitätsinformation berechnet worden ist, und die Kapazitäts- und SOC-Tabelle einer Speichereinheit (140) an die Powerbank durch die erste Kommunikationseinheit (110) zu übermitteln, und
wobei die Speichereinheit (140) dazu eingerichtet ist, die Kapazitäts- und SOC-Tabelle zu speichern, in welcher eine Kapazität für jede OCV und ein Ladezustandsprozentsatz, SOC, aufgezeichnet sind.

7. Verfahren zum Laden eines Batteriepacks (100), umfassend:
einen Kommunikationsverbindungsschritt (S100) eines gegenseitigen Verbindens einer Datenkommunikation zwischen einer Powerbank (200) und einem Batteriepack (100), welcher durch Erhalten von Ladeleistung von der Powerbank (200) geladen wird;
einen Erlangungsschritt (S200) einer Kapazitäts- und Ladezustands-SOC-Tabelle eines Erlangens einer Kapazitäts- und SOC-Tabelle durch die Powerbank (200), in welcher eine Kapazität für jede Leerlaufspannung, OCV, und ein SOC-Prozentsatz aufgezeichnet sind, von dem Batteriepack (100), welcher kommunikativ in dem Kommunikationsverbindungsschritt verbunden wird;
einen Erhaltungsschritt (S300) von gemessenen Kapazitätsinformationen eines Erhaltens einer gemessenen Kapazität gemäß einem gemessenen OCV-Wert des Batteriepacks (100) durch die Powerbank (200) von dem Batteriepack (100), welcher kommunikativ in dem Kommunikationsverbindungsschritt verbunden wird;
einen Berechnungsschritt (S400) von Informationen einer verbleibenden Kapazität eines Berechnens einer verbleibenden Kapazität der Powerbank (200) durch die Powerbank (200);
einen Bestimmungsschritt (S500) eines ladbaren Bereichs eines Vergleichens einer Summenkapazität der berechneten verbleibenden Kapazität der Powerbank (200) und der gemessenen Kapazität des Batteriepacks (100),
welche von dem Batteriepack (100) erhalten wird, mit einer Pufferkapazität des Batteriepacks (100) durch die Powerbank (200), um einen ladbaren Bereich des Batteriepacks (100) gemäß dem Vergleichsergebnis zu bestimmen;
wobei die Pufferkapazität des Ladungs-Zielbatteriepacks die Kapazität entsprechend 100% SOC in der Kapazitäts- und Ladezustands-SOC-Tabelle ist;
und einen Informationsanzeigeschritt (S600) eines Anzeigens des bestimmten ladbaren Bereichsprozentsatzes des Batteriepacks (100) auf einem externen Display durch die Powerbank (200).

8. Verfahren nach Anspruch 7, wobei
der Bestimmungsschritt (S500) eines ladbaren Bereichs umfasst:
einen Kapazitäts-Vergleichsschritt (S510) eines Vergleichens der Summenkapazität der verbleibenden Kapazität der Powerbank, welche in dem Berechnungsschritt von Informationen einer verbleibenden Kapazität berechnet wird, und der gemessenen Kapazität des Batteriepacks (100), welche in dem Erhaltungsschritt von gemessenen Kapazitätsinformationen erhalten wird, mit der Pufferkapazität des Batteriepacks (100), und
einen Ableitungsschritt (S520) einer ladbaren Kapazität eines Ableitens der ladbaren Kapazität des Batteriepacks (100) gemäß dem Vergleichsergebnis in dem Kapazitäts-Vergleichsschritt.

9. Verfahren nach Anspruch 8, wobei,
in dem Ableitungsschritt (S520) einer ladbaren Kapazität,
wenn die Summenkapazität der verbleibenden Kapazität der Powerbank (200) und die gemessene Kapazität des Batteriepacks (100) gleich wie oder größer als die Pufferkapazität des Batteriepacks (100) ist, die ladbare Kapazität des Batteriepacks, als das Ergebnis des Vergleichs in dem Kapazitäts-Vergleichsschritt, als 100% abgeleitet wird.

10. Verfahren nach Anspruch 8, wobei,
in dem Ableitungsschritt (S520) einer ladbaren Kapazität,
wenn die Summenkapazität der verbleibenden Kapazität der Powerbank (200) und die gemessene Kapazität des Batteriepacks (100) kleiner als die Pufferkapazität des Batteriepacks (100) ist, als das Ergebnis des Vergleichs in dem Kapazitäts-Vergleichsschritt, ein SOC-Wert, welcher der Summenkapazität entspricht, von der Kapazitäts- und SOC-Tabelle extrahiert wird, in welcher die Kapazität für jeden OCV und der SOC-Prozentsatz aufgezeichnet sind, welche von dem Batteriepack (100) erlangt wird, und der extrahierte SOC-Wert-Prozentsatz als die ladbare Kapazität des Batteriepacks (100) abgeleitet wird.

## Revendications

1. Chargeur portatif (200) comprenant :
une batterie de chargeur portatif ;
une unité de communication (210) pouvant être connectée à un bloc-batterie cible de charge pour être chargée par communication filaire/sans fil ;
une unité de calcul de capacité restante (220) qui est configurée pour calculer une capacité restante de la batterie de chargeur portatif ;
une unité de réception d'informations (230) qui est configurée pour recevoir des informations de capacité mesurée du bloc-batterie cible de charge et un tableau de capacité et d'état de charge, SOC, du bloc-batterie cible de charge par l'intermédiaire de l'unité de communication (210) ;
une unité de détermination de plage de charge (240) qui est configurée pour comparer une capacité totale de la capacité mesurée du bloc-batterie cible de charge reçue par l'unité de réception d'informations (230) et de la capacité restante du chargeur portatif calculée par l'unité de calcul de capacité restante (220) à une capacité tampon du bloc-batterie cible de charge pour déterminer une plage de charge du bloc-batterie cible de charge selon le résultat de comparaison ; la capacité tampon du bloc-batterie cible de charge étant la capacité correspondant à 100 % du SOC dans le tableau de capacité et d'état de charge, SOC ;
et
une unité d'affichage (250) qui est configurée pour afficher de manière externe la plage de charge du bloc-batterie cible de charge déterminée par l'unité de détermination de plage de charge.

2. Chargeur portatif (200) selon la revendication 1, dans lequel
l'unité de détermination de plage de charge (240) comprend :
une unité de comparaison de capacité (242) qui est configurée pour comparer la capacité totale de la capacité mesurée du bloc-batterie cible de charge reçue par l'unité de réception d'informations (230) et de la capacité restante du chargeur portatif calculée par l'unité de calcul de capacité restante (220) à la capacité tampon du bloc-batterie cible de charge, et
une unité de dérivation de capacité de charge (244) qui est configurée pour dériver un pourcentage de capacité de charge du bloc-batterie cible de charge avec la puissance du chargeur portatif selon le résultat de comparaison de l'unité de comparaison de capacité (242).

3. Chargeur portatif (200) selon la revendication 2, dans lequel
l'unité de dérivation de capacité de charge (244) :
est configurée pour dériver la capacité de charge du bloc-batterie cible de charge comme étant de 100 % lorsque la capacité totale est supérieure ou égale à la capacité tampon du bloc-batterie cible de charge à la suite de la comparaison de l'unité de comparaison de capacité (242), et
extraire une valeur de SOC correspondant à la capacité totale à partir du tableau de capacité et de SOC obtenu à partir du bloc-batterie cible de charge pour déduire le pourcentage de valeur de SOC extraite en tant que capacité de charge du bloc-batterie cible de charge, lorsque la capacité totale est inférieure à la capacité tampon du bloc-batterie cible de charge à la suite de la comparaison de l'unité de comparaison de capacité (242).

4. Chargeur portatif selon la revendication 3, dans lequel
l'unité d'affichage (250) est configurée pour afficher un nombre du pourcentage de valeur de SOC extraite.

5. Système de charge de bloc-batterie configuré pour comprendre le chargeur portatif (200) selon la revendication 1 et un bloc-batterie (100) destiné à être chargé en recevant une puissance de charge du chargeur portatif (200), dans lequel
le bloc-batterie (100) comprend une première unité de communication (110) pour la communication de données.

6. Système de charge de bloc-batterie selon la revendication 5, dans lequel
le bloc-batterie (100) comprend en outre :
une unité de calcul d'informations de capacité (120) qui est configurée pour mesurer une valeur de tension en circuit ouvert, OCV, du bloc-batterie (100) et calculer la capacité mesurée à l'aide de la valeur d'OCV mesurée,
une unité de transmission d'informations (130) qui est configurée pour transmettre la capacité mesurée du bloc-batterie (100) calculée par l'unité de calcul d'informations de capacité (120) et le tableau de capacité et de SOC d'une unité de stockage (140) au chargeur portatif par l'intermédiaire de la première unité de communication (110), et l'unité de stockage (140) est configurée pour stocker le tableau de capacité et de SOC dans lequel une capacité pour chaque OCV et un pourcentage d'état de charge, SOC, sont enregistrés.

7. Procédé de charge d'un bloc-batterie (100) comprenant :
une étape de connexion de communication (S100) consistant à connecter une communication mutuelle de données entre un chargeur portatif (200) et un bloc-batterie (100) chargé en recevant une puissance de charge du chargeur portatif (200) ;
une étape d'obtention de tableau de capacité et d'état de charge, SOC, (S200) consistant à obtenir, au moyen du chargeur portatif (200), un tableau de capacité et de SOC, dans lequel une capacité pour chaque tension en circuit ouvert, OCV et un pourcentage de SOC sont enregistrés, à partir du bloc-batterie (100) qui est connecté en communication dans l'étape de connexion de communication ;
une étape de réception d'informations de capacité mesurée (S300) consistant à recevoir, au moyen du chargeur portatif (200), une capacité mesurée selon une valeur mesurée d'OCV du bloc-batterie (100) en provenance du bloc-batterie (100) qui est connecté en communication dans l'étape de connexion de communication ;
une étape de calcul d'informations de capacité restante (S400) consistant à calculer, au moyen du chargeur portatif (200), une capacité restante du chargeur portatif (200) ;
une étape de détermination de plage de charge (S500) consistant à comparer, au moyen du chargeur portatif (200), une capacité totale de la capacité restante calculée du chargeur portatif (200) et de la capacité mesurée du bloc-batterie (100) reçue en provenance du bloc-batterie (100) à une capacité tampon du bloc-batterie (100) pour déterminer une plage de charge du bloc-batterie (100) selon le résultat de comparaison ;
la capacité tampon du bloc-batterie cible de charge étant la capacité correspondant à 100 % du SOC dans le tableau de capacité et d'état de charge, SOC ;
et
une étape d'affichage d'informations (S600) consistant à afficher, au moyen du chargeur portatif (200), le pourcentage de plage de charge déterminé du bloc-batterie (100) sur un dispositif d'affichage externe.

8. Procédé selon la revendication 7, dans lequel
l'étape de détermination de plage de charge (S500) comprend :
une étape de comparaison de capacité (S510) consistant à comparer la capacité totale de la
la capacité restante du chargeur portatif calculée dans l'étape de calcul d'informations de capacité restante et de la capacité mesurée du bloc-batterie (100) reçue dans l'étape de réception d'informations de capacité mesurée à la capacité tampon du bloc-batterie (100), et
une étape de dérivation de capacité de charge (S520) consistant à dériver la capacité de charge du bloc-batterie (100) selon le résultat de comparaison dans l'étape de comparaison de capacité.

9. Procédé selon la revendication 8, dans lequel
dans l'étape de dérivation de capacité de charge (S520),
lorsque la capacité totale de la capacité restante du chargeur portatif (200) et de la capacité mesurée du bloc-batterie (100) est supérieure ou égale à la capacité tampon du bloc-batterie (100) à la suite de la comparaison dans l'étape de comparaison de capacité, la capacité de charge du bloc-batterie est dérivée comme étant de 100 %.

10. Procédé selon la revendication 8, dans lequel
dans l'étape de dérivation de capacité de charge (520),
lorsque la capacité totale de la capacité restante du chargeur portatif (200) et de la capacité mesurée du bloc-batterie (100) est inférieure à la capacité tampon du bloc-batterie (100) à la suite de la comparaison de l'étape de comparaison de capacité, une valeur de SOC correspondant à la capacité totale est extraite du tableau de capacité et de SOC, dans lequel la capacité pour chaque OCV et le pourcentage de SOC sont enregistrés, obtenu à partir du bloc-batterie (100) et le pourcentage de valeur de SOC extraite est dérivé comme étant la capacité de charge du bloc-batterie (100).
